# EUROPEAN PATENT SPECIFICATION

(11) **EP 2 746 795 B1**
(45) Date of publication and mention of the grant of the patent: **07.10.2015**
(21) Application number: 12198656.6
(22) Date of filing: 20.12.2012
(51) Int. Cl.: G01R 31/34, G01R 33/028

(54) **Device and method for measuring the magnetic field in the air-gap of an electric machine**
Vorrichtung und Verfahren zum Messen des Magnetfeldes im Luftspalt einer Elektromaschine
Dispositif et procédé pour mesurer le champ magnétique dans l'entrefer d'une machine électrique

(43) Date of publication of application: 25.06.2014
(73) Proprietor: ALSTOM Technology Ltd, 5400 Baden (CH)
(72) Inventor: Hobelsberger, Maximilian, 5303 Würenlingen (CH); Honold, Simon Christoph, 4052 Basel (CH); Moser, Roland Richard, 8005 Zürich (CH)
(74) Representative: Alstom Technology Ltd

(56) References cited:
- US-A- 4 667 148
- US-A1- 2009 219 030
- US-B1- 6 466 009

## Description

### TECHNICAL FIELD

The present disclosure relates to a device and method for measuring a magnetic field in an air-gap between a stator and a rotor of an electric machine.

The electric machine is in particular a rotating electric machine such as a synchronous generator to be connected to a gas or steam turbine (turbogenerator) or a synchronous generator to be connected to a hydro turbine (hydro generator) or an asynchronous generator or a synchronous or asynchronous electric motor or also other types of electric machines.

### BACKGROUND

The stators of large electric generators and motors are routinely tested to detect possible interlamination short-circuits.

For example the so-called low-energy test can be used, also known as the "EL CID" test. For this test the stator-core is magnetized to low magnetic flux densities (e.g. 0.1 T), and the surface of the stator bore is scanned to detect magnetic flux generated by eddy currents; these eddy currents are caused by interlamination short-circuits. The detected magnetic flux is then interpreted to detect interlamination short circuits.

In order to carry out this test, an inspection device is placed in the air-gap between the rotor and the stator. Inspection devices have conventional probes made of one magnetic sensor being a large inductive coil.

This magnetic probe, because of its size, does not permit either accurate interlamination short circuits localization, or the determination of the magnetic field geometry.

The consequence is that the interpretation of the results can be incomplete and even incorrect.

In addition, since the air-gap width is normally in the order of 10 to 50 mm, but at the rotor-ends it can be much smaller, for example it can be as low as 9 mm, insertion of the probe in the air-gap or driving of the probe in the air-gap can be troubling.

A flexible probe for detecting time-varying magnetic fields produced in an electric generator is disclosed in US6466009B1. The flexible probe is adapted to be disposed within an air gap formed between an iron stator and a rotatable rotor. An electrostatic shield layer is formed on a front face of the probe and a printed circuit forming at least one coil is printed on the back face. When the flexible probe is used for detecting time-varying magnetic fields, a voltage is induced in the coil when the coil is exposed to a time-varying magnetic field.

A generator air-gap flux probe for determining rate of change of flux density is disclosed in US4667148A, which includes a resilient support spanning the air gap between the stator and the rotor of a dynamoelectric machine to support radial and/or tangential flux coils stably within a short distance of the rotor. The resilient support permits the portion of the flux probe spanning the air gap to deflect substantially during assembly or disassembly of the machine thereby to permit permanent installation of the air-gap flux probe. In one embodiment adapted to longer air gaps, the flux probe is mounted on a pedestal block installed on a dovetail slot wedge in the stator. This reduces the cantilevered distance which the flux probe must span. A tangential flux coil axis stripe marking the axis of the tangential flux coil aids in alignment.

Methods and systems for detecting rotor field ground faults in rotating machinery is disclosed in US2009/219030A1. In one embodiment, a system can include a rotor of the rotating machine comprising a plurality of field windings substantially disposed therein and a stator of the rotating machine comprising a plurality of stator windings substantially disposed therein, with an air gap existing between the rotor and the stator. The system can include a high-impedance grounding circuit at least temporarily connected between the rotor and a ground. Additionally, the system can include an air gap flux probe positioned at least temporarily between the rotor and the stator for measuring a magnetic flux density generated in the air gap during operation of the rotating machine. Finally, the system can further include an analyzer in electrical communication with the air gap flux probe for receiving an output of the air gap flux probe.

### SUMMARY

An aspect of the disclosure includes providing a device and a method that permit accurate interlamination short circuits localization.

These permit an accurate determination of the magnetic field geometry, and an improvement and simplification of the interpretation of the test results.

A device whose probe can be inserted and driven in the air-gap in an easy way is provided.

These aspects are attained by providing a device and method in accordance with the accompanying claims.

### BRIEF DESCRIPTION OF THE DRAWINGS

Further characteristics and advantages will be more apparent from the description of a preferred but non-exclusive embodiment of the device and method, illustrated by way of non-limiting example in the accompanying drawings, in which:

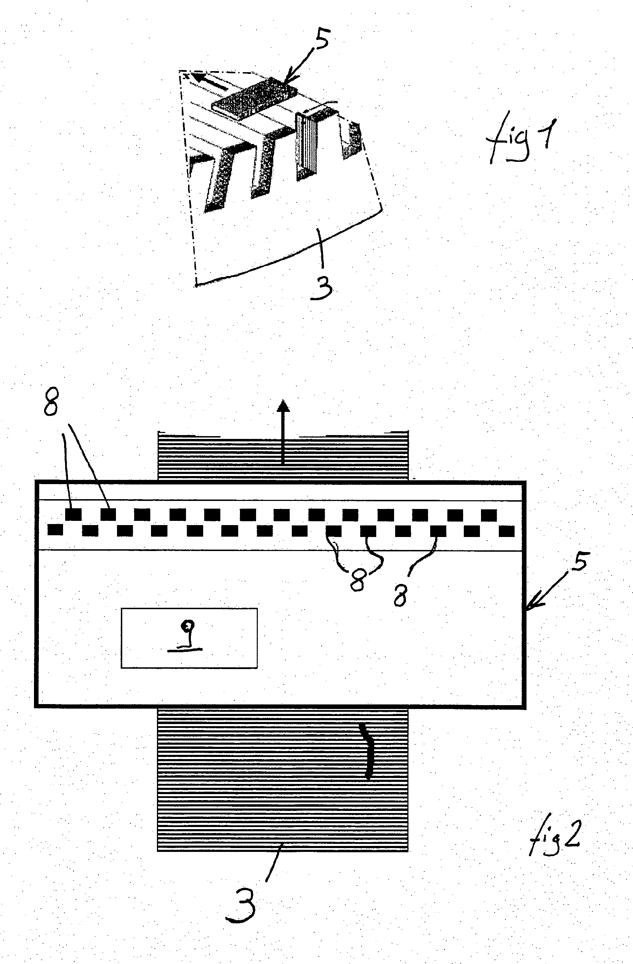

Figure 1 is a perspective view of a device that slides on in a stator bore;
Figure 2 is a top view of a device that slides in a stator bore;
Figure 3 is a schematic view of a device;
Figure 4 is a schematic view of a device with a probe in an air-gap;
Figures 5 and 6 are schematic views of different embodiments of the device.

### DETAILED DESCRIPTION OF EXEMPLARY EMBODIMENTS

The device 1 for measuring a magnetic field in an air-gap 2 between a stator 3 and a rotor 4 of an electric machine comprises a probe 5 to detect the magnetic field and generate a signal indicative thereof, and a display unit 6 (such as a PC with a dedicated software) to display the signal.

The probe 5 includes a plurality of sensors 8.

These sensors 8 are distributed close to each other in one or more rows.

For example, a probe 5 can include a row-shaped arrangement of, for example 100 sensors, which are arranged at a distance of 2 mm apart. The excessive expansion of the scope probe is therefore 200 mm.

Alternatively, the probe 5 can also have two, three or more rows of sensors 8 (these rows can be parallel or not); for example the rows extend in the direction of travel or in a direction perpendicular to the direction of travel. The individual sensors 8 can be in this case located at a greater distance from one another, for example 6 mm. This leads to a simplification of the mechanical assembly.

The sensors are preferably connected to a circuitry 9 that collect their signals, preferably this circuitry 9 is part of the probe 5.

The sensors 8 are inductive sensors.

For example the inductive sensors are applied as a single coil on carrier plate, typically a printed circuit board with etched electrical signal and power conductors. The inductive sensors can also be formed directly on the board. In addition, also other types of magnetic field sensors can be used, for example Hall sensors or magneto-resistive sensors ("XMR" ie GMR, TMR, AMR, etc.). These sensors are suitable due to their small dimensions and can also measure a constant magnetic field.

Also a mixture of different technologies can be used, such as coils with low spatial resolution, combined with Hall sensors with a high resolution.

In a particularly advantageous embodiment, the different sensitivity of the sensors 8 in different directions is used to determine the direction of the magnetic field.

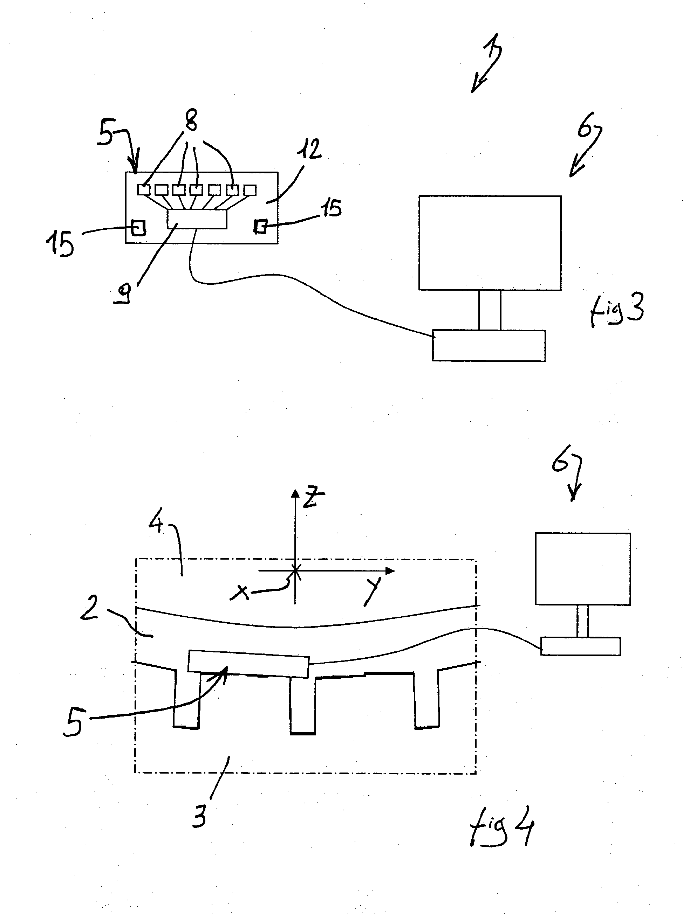

The measurement of the direction can be carried out in all three axes of the Cartesian space, for example (with reference to a stator, see figure 4 in the radial direction of the stator, i.e. in a direction normal to the surface of the stator bore (z axis), in the axial direction of the stator bore and the direction of the stator grooves (x axis) and in the direction perpendicular to the xz plane (y axis), that is normal to the slot directions. Advantageously, however, the magnetic field is measured only in two directions, namely as in z direction and in the y direction, because of the reduced amount of test data that are needed.

The main direction of measurement lies on the z axis, because the local magnetic fields that are caused by the eddy currents typically emerge in this direction. Advantageously, for the multidimensional measurements so-called "integrated" magnetic field sensors can be used; these integrated magnetic field sensors combine all the parts that are necessary for the measurement of the field in two or three Cartesian directions in an electronic component.

For example, the sensor ICs 100 of the company "Sensima Inspections" can be used. This chip also has the circuitry 9 (conversion electronics) co-integrated in it.

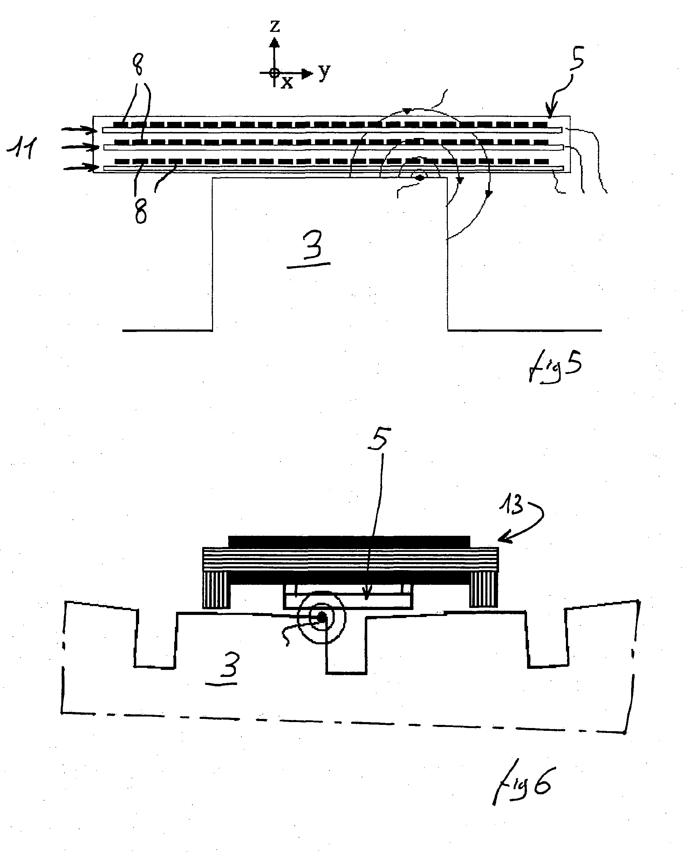

The sensors 8 are disposed in two or more superposed layers 11 (figure 5). These layers 11 are parallel to the surface of the stator bore.

This arrangement makes it possible to measure the magnetic field, not only in a plane parallel to the stator bore surface, but in a spatial domain. Thus, the gradient of the field can be determined in a radial direction, so that the interlamination short-circuits can be located very accurately.

In particular, this embodiment enables to determine the error location in the radial direction, i.e. it helps to establish the depth at which the interlamination short-circuits lie. This can be useful because the location of the interlamination short-circuits defines the repair potential and the potential danger.

The probe can advantageously have a flexible (slightly flexible) support 12; the sensors 8 are connected to the support 12. Since the support 12 is flexible, it can be deformed, for example, to introduce it into the air-gap or to adapt it to the air gap shape (for example to the air-gap curvature).

The probe 5 can also be combined with an excitation unit 13. The excitation unit 13 is preferably small (to easily enter the air-gap 2), magnetically conductive and magnetizable.

By appropriate magnetization of the excitation unit, the stator 3 can be locally magnetized, eliminating the need of magnetization of the whole stator 3.

Because the stator 3 is in this case only locally magnetised, it can be magnetized to higher magnetic field densities without dangerous longitudinal stress.

The magnetization of the excitation unit 13 is carried out either by means of a magnetic core with a coil or by means of an electro-mechanically movable unit, e.g. a rotating magnet. The magnet can be activated by an electric motor. In addition, also one or more infrared sensors 15 can be provided on the probe. These sensors 15 allow to detect the temperature of the stator bore surface and thus to gain further information on the stator zones where interlamination short circuits can be present (interlamination short circuits cause eddy currents and thus stator heating).

The operation of the device is apparent from that described and illustrated and is substantially the following.

The stator 3 is magnetised for example through auxiliary coils (in a traditional way). Then the device 1 is moved in the air-gap.

Since in case of interlamination short circuits in the stator 3, the magnetic field generates eddy currents that in turn generate local magnetic fields; from the detection of these magnetic fields generated by the eddy currents, the interlamination short circuits can be precisely located.

Alternatively, when the probe has the excitation unit 13, there is no need of auxiliary coils and of magnetizing the whole stator 3. In this case only selected parts of the stator 3 where the probe 5 is making the test are locally magnetised.

The present disclosure also refers to a method for measuring a magnetic field in an air-gap between a stator and a rotor of an electric machine. The method comprises providing the device 1 for measuring a magnetic field in an air-gap, magnetizing at least a portion of the stator 3, moving the device 1 on the stator bore, detecting the magnetic field generated by eddy currents that are generated by interlamination short circuits in the stator 3.

Magnetizing can include magnetizing the whole stator or locally magnetizing the stator.

By moving the probe 5 in the air-gap 2, an accurate local image of the magnetic field in the air-gap (on the surface or near the surface of the stator bore) can be obtained. The advantages of the device and method according to the present disclosure can be summarised as follows:
- thanks to the great number of sensors and their size (sub-millimetric and even micrometric scale), the spatial resolution of the measurement is greatly increased. So the actual geometry of the magnetic field generated by the eddy currents and the interlamination short circuit location can be determined with precision,
- a magnetic "map" of the inspected stator surface becomes available, offering a comprehensive reporting and data interpretation tool,
- the small size of the individual sensors allows to build very thin probes,
- due to the multitude of individual sensors, flexible probes can be constructed which can be easily inserted into the air-gap, or which can be adapted to the stator bore curvature. This allows to manufacture and use probes which are quite large in circumferential direction,
- the high-resolution picture of the surface field can be used for a more general diagnosis of the magnetic properties of the stator core in respect of homogeneity, gaps, opened teeth gaps etc.

Naturally the features described may be independently provided from one another.

In practice the materials used and the dimensions can be chosen at will according to requirements and to the state of the art.

## Claims

1. A device(1) for measuring a magnetic field in an air-gap between a stator (3) and a rotor (4) of an electric machine, the device comprising a probe (5) to detect the magnetic field and generate a signal indicative thereof and a display unit(6) for the signal, **characterised in that** the probe (5) includes a plurality of sensors (8), wherein the plurality of sensors (8) are disposed in two or more superposed layers(11), and wherein the two or more superposed layers (11) are arranged such that, in use, the two or more superposed layers(11) are parallel to the surface of a stator bore of the stator (3).

2. The device of claim 1, **characterised in that** the plurality of sensors (8) are aligned along at least one row.

3. The device of claim 1, **characterised in that** the sensors (8) include inductive sensors, preferably inductive coils.

4. The device of claim 1, **characterised in that** the sensors (8) include Hall sensors and/or magneto-resistive sensors.

5. The device of claim 1, **characterised in that** the sensors (8) have different sensitivity in different directions.

6. The device of claim 1, **characterised in that** the probe (5) includes a support (12) that carries the sensors (8).

7. The device of claim 6, **characterised in that** the support (12) is a flexible support.

8. The device according to claim 1, **characterised by** comprising an excitation unit(13) for generating a localised magnetic field.

9. The device of claim 1, **characterised by** further comprising at least one infrared sensor (15).

10. Method for measuring a magnetic field in an air-gap between a stator (3) and a rotor (4) of an electric machine, the method comprising providing a device(1) according to claim 1, magnetizing at least a portion of the stator (3), moving the device(1) on the stator bore, detecting the magnetic field generated by eddy currents that are generated by interlamination short circuits in the stator (3).

11. The method according to claim 10, **characterised by** magnetizing the whole stator.

12. The method according to claim 10, **characterised by** locally magnetizing the stator.

## Patentansprüche

1. Vorrichtung (1) zum Messen eines Magnetfeldes in einem Luftspalt zwischen einem Stator (3) und einem Rotor (4) einer elektrischen Maschine, wobei die Vorrichtung eine Sonde (5), um das Magnetfeld zu erfassen und ein dieses kennzeichnendes Signal zu erzeugen, und eine Anzeigeeinheit (6) für das Signal aufweist, **dadurch gekennzeichnet, dass** die Sonde (5) mehrere Sensoren (8) aufweist, wobei die mehreren Sensoren (8) in zwei oder mehr übereinander liegenden Schichten (11) angeordnet sind und wobei die zwei oder mehr übereinander liegenden Schichten (11) derart angeordnet sind, dass im Gebrauch die zwei oder mehr übereinander liegenden Schichten (11) parallel zu der Oberfläche einer Statorbohrung des Stators (3) sind.

2. Vorrichtung nach Anspruch 1, **dadurch gekennzeichnet, dass** die mehreren Sensoren (8) entlang wenigstens einer Reihe ausgerichtet sind.

3. Vorrichtung nach Anspruch 1, **dadurch gekennzeichnet, dass** die Sensoren (8) induktive Sensoren beinhalten, insbesondere induktive Spulen.

4. Vorrichtung nach Anspruch 1, **dadurch gekennzeichnet, dass** die Sensoren (8) Hall-Sensoren und/oder magnetoresistive Sensoren beinhalten.

5. Vorrichtung nach Anspruch 1, **dadurch gekennzeichnet, dass** die Sensoren (8) in unterschiedlichen Richtungen eine unterschiedliche Empfindlichkeit aufweisen.

6. Vorrichtung nach Anspruch 1, **dadurch gekennzeichnet, dass** die Sonde (5) einen Träger (12) aufweist, welcher die Sensoren (8) trägt.

7. Vorrichtung nach Anspruch 6, **dadurch gekennzeichnet, dass** der Träger (12) ein flexibler Träger ist.

8. Vorrichtung nach Anspruch 1, **dadurch gekennzeichnet, dass** sie eine Erregungseinheit (13) zum Erzeugen eines lokalisierten Magnetfeldes aufweist.

9. Vorrichtung nach Anspruch 1, **dadurch gekennzeichnet, dass** sie ferner wenigstens einen Infrarotsensor (15) aufweist.

10. Verfahren zum Messen eines Magnetfeldes in einem Luftspalt zwischen einem Stator (3) und einem Rotor (4) einer Elektromaschine, wobei das Verfahren aufweist: Bereitstellen einer Vorrichtung (1) nach Anspruch 1, Magnetisieren wenigstens eines Abschnitts des Stators (3), Bewegen der Vorrichtung (1) auf der Statorbohrung, Erfassen des Magnetfeldes, das durch Wirbelströme erzeugt wird, welche durch Blechschlüsse in dem Stator (3) erzeugt werden.

11. Verfahren nach Anspruch 10, **gekennzeichnet durch** Magnetisieren des gesamten Stators (3).

12. Verfahren nach Anspruch 10, **gekennzeichnet durch** lokales Magnetisieren des Stators (3).

## Revendications

1. Dispositif (1) servant à mesurer un champ magnétique dans un entrefer entre un stator (3) et un rotor (4) d'une machine électrique, le dispositif comprenant une sonde (5) pour détecter le champ magnétique et générer un signal révélateur dudit champ magnétique, et une unité d'affichage (6) du signal, **caractérisé en ce que** la sonde (5) comprend une pluralité de capteurs (8), la pluralité de capteurs (8) étant disposés dans au moins deux couches superposées (11), et les au moins deux couches superposées (11) étant disposées de telle sorte que, lors de l'utilisation, les au moins deux couches superposées (11) soient parallèles à la surface d'un alésage de stator du stator (3).

2. Dispositif selon la revendication 1, **caractérisé en ce que** la pluralité de capteurs (8) sont alignés le long d'au moins une rangée.

3. Dispositif selon la revendication 1, **caractérisé en ce que** les capteurs (8) incluent des capteurs d'induction, de préférence des bobines d'induction.

4. Dispositif selon la revendication 1, **caractérisé en ce que** les capteurs (8) incluent des capteurs Hall et/ou des capteurs magnétorésistifs.

5. Dispositif selon la revendication 1, **caractérisé en ce que** les capteurs (8) ont une sensibilité différente dans différentes directions.

6. Dispositif selon la revendication 1, **caractérisé en ce que** la sonde (5) comprend un support (12) qui supporte les capteurs (8).

7. Dispositif selon la revendication 6, **caractérisé en ce que** le support (12) est un support flexible.

8. Dispositif selon la revendication 1, **caractérisé en ce qu'**il comprend une unité d'excitation (13) servant à générer un champ magnétique localisé.

9. Dispositif selon la revendication 1, **caractérisé en ce qu'**il comprend au moins un capteur infrarouge (15).

10. Procédé servant à mesurer un champ magnétique dans un entrefer entre un stator (3) et un rotor (4) d'une machine électrique, le procédé consistant à fournir un dispositif (1) selon la revendication 1, magnétiser au moins une partie du stator (3), déplacer le dispositif (1) sur l'alésage de stator, détecter le champ magnétique générer par les courants de Foucault qui sont générés par des courts-circuits entre tôles dans le stator (3).

11. Procédé selon la revendication 10, **caractérisé en ce qu'**il consiste à magnétiser le stator (3) entier.

12. Procédé selon la revendication 10, **caractérisé en ce qu'**il consiste à magnétiser localement le stator (3) .
